Europäisches Patentamt

European Patent Office

Office européen des brevets

(11) Publication number: **0 273 481 B1**

# EUROPEAN PATENT SPECIFICATION

(45) Date of publication of patent specification: **09.09.92**  (51) Int. Cl.⁵: **G01R 33/06**

(21) Application number: **87202294.2**

(22) Date of filing: **24.11.87**

(54) **Non-oriented gear tooth sensor using a Hall cell.**

(30) Priority: **25.11.86 US 934873**

(43) Date of publication of application:
**06.07.88 Bulletin 88/27**

(45) Publication of the grant of the patent:
**09.09.92 Bulletin 92/37**

(84) Designated Contracting States:
**DE FR GB IT**

(56) References cited:
**DE-A- 3 426 784**
**US-A- 4 204 158**

(73) Proprietor: **North American Philips Corporation**
**100 East 42nd Street 9th Floor**
**New York, N.Y. 10017(US)**

(72) Inventor: **Carr, Ronald E.**
**c/o INT. OCTROOIBUREAU B.V. Prof. Holstlaan 6**
**NL-5656 AA Eindhoven(NL)**
Inventor: **Schneider, Matthew Lee**
**c/o INT. OCTROOIBUREAU B.V. Prof. Holstlaan 6**
**NL-5656 AA Eindhoven(NL)**
Inventor: **Payne, Paul Edwin**
**c/o INT. OCTROOIBUREAU B.V. Prof. Holstlaan 6**
**NL-5656 AA Eindhoven(NL)**

(74) Representative: **Veenstra, Gustaaf et al**
**INTERNATIONAAL OCTROOIBUREAU B.V.**
**Prof. Holstlaan 6**
**NL-5656 AA Eindhoven(NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The invention relates to a gear tooth sensor to sense the presence or absence of gear teeth or similar shapes as they rotate past a senor, comprising:

a single permanent magnet;

a Hall cell integrated circuit positioned adjacent to one polar end of said magnet such that the flux lines from said magnet have essentially no component perpendicular to the planar face of said Hall cell;

means to steer and concentrate the flux lines of said magnet perpendicular to the planar surface of said Hall cell when said flux lines are modulated by the presence of a ferrous gear tooth or similar shape, said means including a pair of spaced apart flux concentrators of soft iron material secured to said magnet, one of said flux concentrators being positioned respectively at each planar face side of said Hall cell.

Sensors of this kind (see e.g. U.S. A-4.204.158) can be used as motion, edge, frequency and speed sensors or counting devices. In particular, they are used as gear tooth sensors which sense the presence or absence of gear teeth as they rotate past a sensor device.

As a preliminary note, the basic Hall sensor is simply a small sheet of semiconductor material. A constant voltage source forces a constant bias current to flow in the longitudinal direction in the semiconductor sheet. The output, a voltage measured across the width of the sheet, reads near zero if a magnetic field is not present. If the biased Hall sensor is placed in a magnetic field oriented at right angles to the Hall current, the voltage output is in direct proportion to the strength of the magnetic field. This is the Hall effect, discovered by E.H. Hall in 1879. The basic Hall sensor is essentially a transducer that will respond with an output voltage if the applied magnetic field changes in any manner. Information about Hall sensors, also known as Hall cells, is widely available in the literature.

The prior art has taught that when a Hall cell is placed in a magnetic field such that lines of magnetic induction (flux) are normal (perpendicular) to the plane of the cell, an electric unbalance occurs which can be used to detect this field. This principle of operation is well documented in "Sprague Integrated Circuits Data Book", WR-503, in Section 9, published by Sprague Electric Company, North Adams, Mass. Generally it is recognized that Hall cells, including the integrated electronic circuits, can be operated by a unidirectional field where the parameter B (flux density) expressed in Gauss can be modulated by sufficient means to produce a level of flux either below or above a threshold level which is established by either a bias flux level or by an electronic bias in the circuit reading the Hall cell. This type of component is termed a Hall digital switch, and is typified by Sprague UGN 3040T described on page 9-11 of the above-cited Sprague Data Book.

It is also recognized that these Hall cells, including the integrated electronic circuits, can be operated by a bidirectional field wherein the parameter B (flux density) expressed in Gauss can be alternated in polarity to produce flux passing through the cell first in one direction and then in the other direction. This type of component is termed a Hall digital latch and is typified by UGN 3075T on page 9-15 of the above-cited Sprague Data Book.

The Sprague Data Book also illustrates a technique for detecting what could be termed "gear teeth", but this technique has the disadvantage that the elctronics are A-C coupled and therefore cannot be used where direct coupling is required.

U.S. Application 4.204.158 discloses a technique for a direct coupled gear tooth sensor, in which a permanent magnet has two extensions of soft iron appended to one polar end. These two extensions are flux steering parts or concentrators. A Hall cell integrated circuit package is placed between the two concentrators such that the planar surface of the Hall cell is parallel to the interior planar surfaces of the two flux concentrators. With the two concentrators appended to one polar end of the magnet and a Hall cell integrated circuit positioned between the two concentrators, the normal flux lines at the center of the end of the magnet will be substantially parallel to the planar surface of the Hall cell. As a gear tooth passes one of the two flux steering concentrators, the flux is steered through the concentrators to produce a component perpendicular to the Hall cell.

In this known magnetic sensor, the sensor and the gear being sensed must have some specific orientation relative to each other such that a passing gear can modulate the flux field to produce a level of flux above or below a threshold, or such that a passing gear can alternate the polarity of the flux field, either of which can be detected and interpreted.

It is an object of the present invention to provide a sensor that overcomes the need for relative orientation by incorporating a unique configuration of flux steering guides and a Hall cell.

The sensor according to the invention is characterized in that a first flux concentrator is positioned on a first planar side of said Hall cell integrated circuit such that said first flux concentrator has one end aligned with the center line of said Hall cell integrated circuit, thereby being adjacent to and spaced apart from a first half of said Hall cell integrated circuit at said first planar side, and a second flux concentrator is positioned on an opposed second planar side of said Hall cell integrated circuit such that said second flux concentrator has one end aligned with the center line of said Hall cell integrated circuit, thereby being adjacent to and spaced apart from a second half of said Hall cell at said second planar surface side.

Each of the flux concentrators extends outward from the center line of the Hall cell circuit in opposed directions, forming a stepped arrangement. By placing the one edge of each flux concentrator at the center of the Hall cell in the stepped arrangement, the Hall cell will operate independently of its relative orientation towards the gear because the concentrators are more effective in directing and concentrating more of the flux through the area of the Hall cell itself than other embodiments. This concentration of flux through the Hall cell improves the sensitivity of the sensor. A further advantage is that a greater air gap is possible in many applications and with some sizes of gears. In certain applications, the air gap can be optimized when the top surfaces of the flux guides are flush with the top edges of the Hall cell package.

The invention will now be explained in detail with reference to the drawings, in which

Figures 1, 2 and 3 are diagrammatic views of a gear tooth sensor showing a gear approaching the sensor in Figure 1, the gear centered under the sensor in Figure 2, and the gear leaving the sensor in Figure 3;

Figure 4 is a perspective view of an embodiment of the non-oriented direct coupled gear sensor of the present invention, the sensor being situated in a cylindrical housing, partially cut-away in the figure;

Figure 5 is a perspective view of the sensor of Figure 4;

Figure 6 is a top view of the sensor of Figure 4.

Figure 7 is a top plan view of the gear sensor of Figure 4 showing the concentration of flux lines through the sensor when the sensor has a first orientation to a gear tooth;

Figure 8 is a top plan view of the gear sensor of Figure 4 showing the concentration of flux lines through the sensor when the sensor is rotated 90° from the first orientation to a gear tooth.

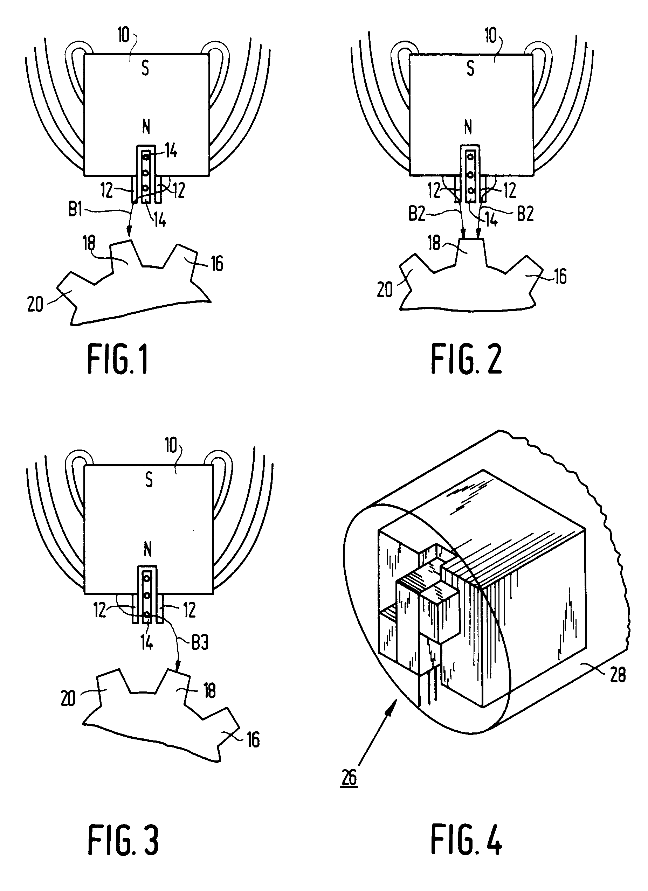

An embodiment of the non-oriented direct coupled gear sensor of the present invention is illustrated in Figures 4 through 6 of the drawings. To understand the contribution of this invention in contest, the type of gear tooth sensors, to which the invention pertains, will be discussed first.

A gear tooth sensor using a single magnet and a Hall cell integrated circuit to sense the presence or absence of gear teeth as they rotate past the sensor, is illustrated in Figures 1, 2 and 3. In these figures, a permanent magnet 10 has joined thereto two spaced apart protrustions on one polar end, these protrusions serving as flux steeering parts or flux concentrators 12. Flux concentrators 12 are made of substantially soft iron material. A Hall cell integrated circuit 14 which can have a as a part thereof either a digital latch or a digital switch is positioned between said flux concentrators 12, the plane of said Hall cell being substantially parallel to the interior planar sides of flux concentrators 12. In the embodiment of Figures 1, 2 and 3, Hall cell intergrated circuit 14 is recessed within magnet 10.

The reason that the integrated circuit 14 is recessed in the planar surface of magnet 10 is that the Hall cell itself is only a small portion of the integrated circuit package. For the invention to operate optimally, the Hall cell itself should be as close as possible to the planar surface of one polar end of magnet 10. Therefore, the integrated circuit package 14 is recessed to achieve this goal. Obviously, if the package were recessed too deeply such that the Hall cell itself were recessed, the sensor would not operate. In these figures the flux lines represent only the path and direction of the flux through concentrators 12. They do not indicate the intensity or strength of the flux. As gear teeth rotate past the Hall cell in circuit 14, the flux perpendicular to the face or plane of the Hall cell is zero when a tooth is directly balanced below the Hall cell and the flux concentrators 12. As a given tooth is displaced to one side or the other, the flux is steered through one of the concentrators 12 to produce a component perpendicular to the Hall cell, causing a complete flux reversal with each passing gear tooth. This is illustrated in Figures 1, 2 and 3, in which a gear having teeth 16, 18 and 20 is shown rotating in a clockwise direction. As gear tooth 16 is departing from the flux around magnet 10, the flux lines thereto become weaker while the leading edge of gear tooth 18 is entering the field just below flux concentrators 12 and Hall cell in circuit 14. The effect is that some of the flux lines from the right hand concentrator 12 will be steered perpendicular to the Hall cell and downward to the leading edge of gear tooth 18 as shown in Figure 1 (flux path $B_1$). When gear tooth 18 is fully centered under flux concentrators 12 and Hall. cell in circuit 14, the normal flux patterns will prevail and there will be no component of the flux perpendicular to Hall cell in circuit 14, as shown in Figure 2 (flux path $B_2$). As the trailing edge of gear tooth 18 moves out of the flux pattern, some flux lines from the left concentrator 12 are steered perpendicular to the Hall cell and then down toward the trailing edge of tooth 18 causing a flux reversal from the flux pattern of Figure 1, as is illustrated in Figure 3 (flux path $B_3$). In this embodiment the Hall cell could be the model 3050 latch of Sprague. It is the horizontal component of the flux passing through one concentrator to the plane of the Hall cell to an approaching or departing gear tooth which causes the flux reversal. In this embodiment, the concentrators 12 serve to steer the flux to and across the Hall cell. In the balanced condition illustrated in Figure 2 the flux lines have no component perpendicular to the face of the cell.

Figure 4 is a perspective view of an embodiment of the non-oriented direct coupled gear sensor 26 of the present invention, wherein the non-oriented sensor is shown positioned in a cylindrical housing 28. When the sensor in its housing is installed in a working environment, it may not always be possible. to control its orientation vis-a-vis a gear whose teeth it senses. In a typical magnetic sensor, the sensor and the gear being sensed must have some specific orientation relative to each other such that a passing gear can modulate the flux field to produce a level of flux above or below a threshold, or such that a passing gear can alternate the polarity of the flux field, either of which can be detected and interpreted. The non-oriented sensor of the present invention overcomes the need for relative orientation by incorporating a unique configuration of flux steering guides and a Hall cell.

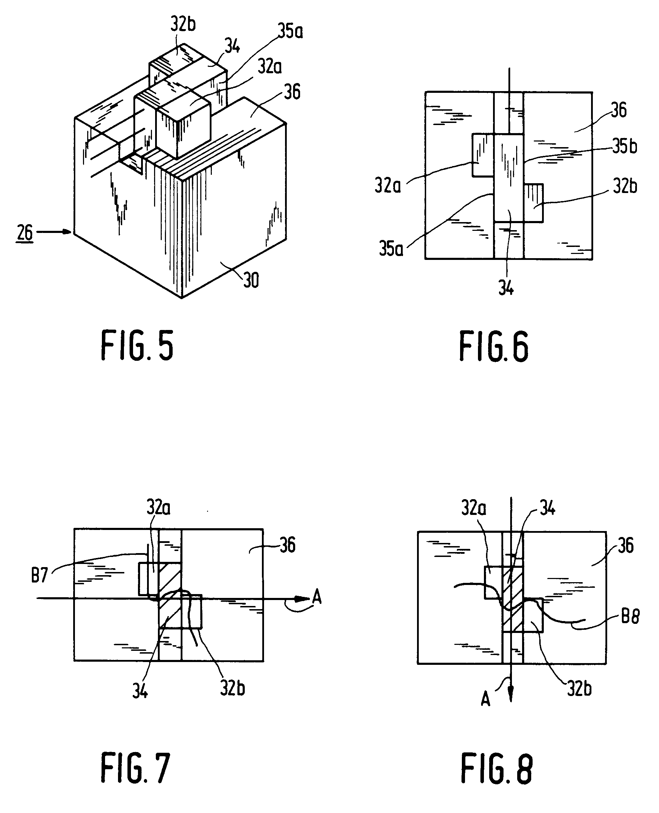

Turning now to Figures 5 and 6, the non-oriented direct coupled gear sensor 26 of the present invention comprises a permanent magnet 30, which may be of any suitable shape, a Hall cell integrated circuit 34 positioned perpendicular to the planar surface 36 of one polar end of said magnet, and a pair of flux concentrators 32a and 32b. The Hall cell integrated circuit package 34 includes a Hall cell and appropriate circuitry to constitute a digital switch or a digital latch, such a Sprague UGN 3040T or UGN 3075T, respectively. Thus the integrated circuit package 34 is significantly larger than the Hall cell itself contained therein. For the optimal performance of the sensor of the present invention, the Hall cell contained in integrated circuit 34 should be perpendicular to the plane of polar surface 36 of permanent magnet 30 and as close to said surface as possible. For this reason the Hall cell integrated circuit 34 is recessed slightly into magnet 30. Obviously, the Hall cell itself must be above surface 36; only other portions of the package are recessed.

Flux concentrators 32a and 32b are protrusions of soft iron or a similar material perpendicular to polar surface 36 and positioned on either side of Hall cell integrated circuit 34 such that an interior planar surface of flux concentrator 32a is substantially parallel to and adjacent to a first half of a first planar surface 35a of integrated circuit 34, while an interior planar surface of flux concentrator 32b is substantially parallel to and adjacent to a second half of a second planar surface 35b of integrated circuit 34, said first and second planar surfaces being on opposed sides of integrated circuit 34 and said first and second halves being displaced relative to one another. Thus flux guide 32a ispositioned such that one edge is substantially even with a perpendicular center line through Hall cell integrated circuit 34, on a first said of said circuit. Flux guide 32b is positioned such that one edge is substantially even with a perpendicular center line through Hall cell integrated circuit 34, on a second side of said circuit. The flux concentrators have no fixed size or dimensions, but neither one can extend beyond the centerline of the Hall cell circuit.

It is advantageous that the height of theflux concentrators 32a, 32b and the Hall cell package 34 be equal so that their top edges are flush. Such height relationship permits an optimal air gap in many applications.

Thus the invention is a novel way of using a non-oriented direct coupled Hall device with a single magnet for sensing gear teeth or other discontinuities of iron targets. The preferred embodiment of Figures 4 through 8 shows a typical configuration with flux concentrators. In this configuration changing the distance between the gear tooth and the edge of the Hall cell within nominal practical limits does not radically effect the Hall cell operation. This is one of the features of the invention in that tolerances are more liberal than with prior art devices. Figures 7 and 8 show conditions which obtain as a gear tooth passes the Hall cell in the direction indicated by the arrow A, when the sensor has a first orientation (similar to the orientation shown in figures 1 - 3) as in Figure10, or rotated 90° from the first orientation (non-oriented) as in Figure 11. In these figures the magnetic flux B is represented by the flux paths B7 and B8 respectively. The direction of B is changed by the presence of the gear tooth such that a component of B is perpendicular to the plane of the Hall cell. As the tooth advances the direction of B reverses the component of B perpendicular to the plane of the Hall cell. An important parameter is the magnitude of the component of the B vector which is perpendicular to the Hall cell.

There are several factors which influence the performance of the sensor. These are the size of the gear teeth including ther spacing between them; the closeness of the teeth to the Hall cell which is buried in the Hall cell package; the magnitudfe of theflux which is available to be modulated by the gear teeth; the sensitivity of the Hall digital latch; the enhancements of flux guides or concentrators and the thinness of the Hall cell package. The packaging of the Hall cell has to be done with optimization of the package placing the sensitive plane of the Hall cell such that it is accessible by flux through the smallest dimension of the package for optimal operation.

The flux guides or concentrators 32a, 32b improve the overall performance of the sensor. The concentrators are usually proportional to the Hall cell package size which can vary from device to device. It is recognized that the specific dimensions of the concentrators must be optimized in shape and size to obtain maximum performance.

It should be noted that the precise configuration of the magnet 30 whether it be a hexahedral or a cylindrical shape is not relevant to the function of the invention. In the drawings, the three package leads of the Hall cell are shown as either three dots or three short parallel lines.

The Hall cell is basically being used to sense a ferrous or other ferromagnetic object directly, and not the conventional way by passing a magnet or by interrupting a magnetic field with a vane as used on most of the ignition systems in the auto industry. The invention enables one to bend or steer and concentrate the linesd of flux to overcome the operate or release point of a particular Hall device. The preferred embodiment is in effect a better mechanical device than heretofore known and it relies upon steering and concentration of the flux lines one way and then the other to achieve a flux reversal. This arrangement makes it possible to manufacture a very sensitive device with consistency and reliability.

Variations in the placement of the flux concentrators and the Hall cell integrated cirucit as well as their angular position on one polar surface of the magnet are possible. It is also obvious that improved packaging for the Hall cell integrated circuit may eliminate the desirability of recessing the package in the magnet. Only the preferred embodiment is illustrated and described herein.

## Claims

1. A gear tooth sensor (26) to sense the presence or absence of gear teeth or similar shapes as they rotate past a sensor, comprising:

    a single permanent magnet (30);

    a Hall cell integrated circuit (34) positioned adjacent to one polar end of said magnet (30) such that the flux lines from said magnet (30) have essentially no component perpendicular to the planar face of said Hall cell integrated circuit (34);

    means (32a,b) to steer and concentrate the flux lines of said magnet (30) perpendicular to the planar surface of said Hall cell integrated circuit (34) when said flux lines are modulated by the presence of a ferrous gear tooth or similar shape, said means (32a,b) including flux concentrators (32a,b) of soft iron material secured to said magnet (30), one of said flux concentrators (32a,b) being positioned respectively at each planar face side of said Hall cell integrated circuit (34), characterized in that a first flux concentrator (32a) is positioned on a first planar side of said Hall cell integrated circuit (34) such that said first flux concentrator (32a) has one end aligned with the center line of said Hall cell integrated circuit (34), thereby being adjacent to and spaced apart from a first half of said Hall cell integrated circuit (34) at said first planar side, and a second flux concentrator (32b) is positioned on an opposed second planar side of said Hall cell integrated circuit (34) such that said second flux concentrator (32b) has one end aligned with the center line of said Hall cell integrated circuit (34), thereby being adjacent to and spaced apart from a second half of said Hall cell integrated circuit (34) at said second planar surface side.

2. A sensor as claimed in Claim 1, characterized in that the first flux concentrator (32a) is substantially parallel with the first half of said Hall cell integrated circuit (34) at said first planar side, and the second flux concentrator (32b) is substantially parallel with the second half of said Hall cell integrated circuit (34) at said second planar surface side.

3. A sensor as claimed in Claim 1 or 2, characterized in that said Hall cell integrated circuit (34) is partially recessed in said magnet (30).

4. A sensor as claimed in Claim 1, 2 or 3, characterized in that said flux concentrators (32a,b) have the same height as said Hall cell integrated circuit (34).

## Patentansprüche

1. Getriebezahn-Sensor (26) zum Messen des möglichen Vorhandenseins von Getriebezähnen oder ähnlicher Formen, wenn sie im Drehen einen Sensor passieren, mit nur einem Dauermagneten, einer integrierten Schaltung (34) mit einer Hall-Zelle, wobei die Schaltung neben einem Polarende des Magneten (30) derart angeordnet ist, daß die vom Magneten (30) ausgehenden Flußlinien im wesentlichen keinen Bestandteil senkrecht zur Planarfläche der integrierten Schaltung (34) mit der Hall-Zelle vorzeigen, mit Mitteln (32a,b) zum Steuern und Konzentrieren der Flußlinien des Magneten (30) senkrecht zur Planarfläche der integrierten Schaltung (34) mit der Hall-Zelle, wenn die Flußlinien durch das Vorhandensein eines Getriebe-Eisenzahns oder einer ähnlichen Form moduliert werden, wobei die Mittel (32a,b) auf dem Magneten (30) befestigte Flußkonzentratoren (32a,b) aus Weicheisen enthalten und einer der Flußkonzentratoren (32a,b) auf je einer der Planarseiten der integrierten Schaltung (34) mit der Hall-Zelle angeordnet ist, dadurch gekennzeichnet, daß ein erster Flußkonzentrator (32a) auf einer ersten Planarseite der integrierten Schaltung (34) mit der Hall-Zelle derart angeordnet ist, daß das eine Ende des ersten Flußkonzentrators (32a) mit der Mittellinie der integrierten Schaltung (34) mit der Hall-Zelle fluchtet, und der erste Flußkonzentrator einer ersten Hälfte der integrierten Schaltung (34) mit der Hall-Zelle an der ersten Planarseite benachbart ist und im Abstand davon liegt, und ein zweiter Flußkonzentrator (32b) an einer gegenüberliegenden zweiten Planarseite der integrierten Schaltung (34) mit der Hall-Zelle derart angeordnet ist, daß das eine Ende des zweiten Flußkonzentrators (32b) mit der Mittellinie der integrierten Schaltung (34) mit der Hall-Zelle fluchtet, und der zweite Flußkonzentrator einer zweiten Hälfte der integrierten Schaltung (34) mit der Hall-Zelle an der ersten Planarseite benachbart ist und im Abstand davon liegt.

2.  Fühler nach Anspruch 1,
    dadurch gekennzeichnet, daß der erste Flußkonzentrator (32a) im wesentlichen zur ersten Hälfte der integrierten Schaltung (34) mit der Hall-Zelle an der ersten Planarseite parallel verläuft, und der zweite Konzentrator (32b) im wesentlichen zur zweiten Hälfte der integrierten Schaltung (34) mit der Hall-Zelle an der zweiten Planarseite parallel verläuft.

3.  Fühler nach Anspruch 1 oder 2,
    dadurch gekennzeichnet, daß die integrierte Schaltung (34) mit der Hall-Zelle zum Teil in den Magneten (30) eingelassen ist.

4.  Fühler nach Anspruch 1, 2 oder 3,
    dadurch gekennzeichnet, daß die Flußkonzentratoren (32a,b) genau so hoch sind wie die Schaltung (34) mit der Hall-Zelle.

**Revendications**

1.  Capteur de dent d'engrenage (26) pour détecter la présence ou l'absence de dents d'engrenage ou de formes analogues lorsqu'elles passent en rotation devant un capteur, comportant:
    un seul aimant permanent (30);
    un circuit intégré (34) à élément à effet Hall placé à côté de l'une des extrémités polaires dudit aimant (30) de façon que les lignes de flux issues dudit aimant (30) n'ont essentiellement aucune composante perpendiculaire à la face plane dudit circuit intégré à élément à effet Hall (3);
des moyens (32a, b) pour commander et concentrer les lignes de flux dudit aimant (30) perpendiculairement à la surface plane dudit circuit intégré à élément à effet Hall (34) lorsque lesdites lignes de flux sont modulées par la présence d'une dent d'engrenage en matériau ferreux ou d'une forme analogue, moyens (32a, b) comportant une paire de concentrateurs de flux (32a, b) de fer doux fixés audit aimant (30), l'un desdits concentrateurs de flux (32a, b) étant positionné respectivement sur l'une et l'autre des faces planes dudit élément à effet Hall (34), caractérisé en ce que, sur une première face plane dudit circuit intégré à élément Hall (34), est positionné un premier concentrateur de flux (32a), de telle manière que ledit premier concentrateur de flux (32a) a une extrémité alignée avec la ligne centrale dudit circuit intégré à élément à effet Hall (34) de façon à être voisin d'une première moitié dudit circuit intégré à effet Hall, sur ladite première face plane, tout en étant séparé par un intervalle de cette moitié, et en ce que, sur une seconde face plane opposée dudit circuit intégré à élément à effet Hall (34) est positionné un second concentrateur de flux (32b), de telle manière que ledit second concentrateur de flux (32b) a une extrémité alignée avec la ligne centrale dudit circuit intégré à élément à effet Hall (34) de façon à être voisin d'une seconde moitié dudit circuit intégré à élément à effet Hall (34), sur ladite seconde face plane (34), tout en étant séparé par un intervalle de cette moitié.

2.  Capteur selon la revendication 1, caractérisé en ce que le premier concentrateur de flux (32a) est sensiblement parallèle à la première moitié du circuit intégré à élément à effet Hall (34), sur ladite première face plane, et en ce que le second concentrateur de flux (32b) est sensiblement parallèle à la seconde moitié dudit circuit intégré à élément à effet Hall (34), sur ladite seconde face plane.

3.  Capteur selon la revendication 1 ou 2, caractérisé en ce que ledit circuit intégré à élément à effet Hall (34) est partiellement renfoncé dans ledit aimant (30).

4.  Capteur selon la revendication 1, 2 ou 3, caractérisé en ce que lesdits concentrateurs de flux (32a, b) ont la même hauteur que ledit circuit intégré à élément à effet Hall (34).

FIG.1

FIG. 2

FIG. 3

FIG. 4

FIG.5

FIG.6

FIG.7

FIG.8